Europäisches Patentamt

European Patent Office

Office européen des brevets

(19)

(11) Veröffentlichungsnummer : **0 032 688**
**B1**

(12) **EUROPÄISCHE PATENTSCHRIFT**

(45) Veröffentlichungstag der Patentschrift :
04.07.84

(21) Anmeldenummer : **81100117.1**

(22) Anmeldetag : **09.01.81**

(51) Int. Cl.³ : **B 65 G 47/12**, H 02 K 41/02,
H 05 K 13/02

(54) **Vorrichtung zum Vereinzeln und Ordnen von sich verhakenden im Haufwerk vorliegenden metallischen Werkstücken.**

(30) Priorität : **22.01.80 DE 3002168**

(43) Veröffentlichungstag der Anmeldung :
**29.07.81 Patentblatt 81/30**

(45) Bekanntmachung des Hinweises auf die Patenterteilung : **04.07.84 Patentblatt 84/27**

(84) Benannte Vertragsstaaten :
**AT BE CH DE FR GB IT LI LU NL SE**

(56) Entgegenhaltungen :
**DD-A- 136 580**
**DE-A- 2 639 087**
**DE-A- 2 709 971**
**DE-B- 1 963 529**
**DE-B- 1 964 684**
**DE-B- 2 222 326**
**US-A- 3 645 377**
**US-A- 3 679 097**

(73) Patentinhaber : **SIEMENS AKTIENGESELLSCHAFT**
**Berlin und München Wittelsbacherplatz 2**
**D-8000 München 2 (DE)**

(72) Erfinder : **Haeusler, Jochen, Dr.**
**Happurger Strasse 111**
**D-8500 Nürnberg-Laufamholz (DE)**

## Beschreibung

Die Erfindung bezieht sich auf eine Vorrichtung zum Vereinzeln und Ordnen von sich verhakenden im Haufwerk vorliegenden metallischen Werkstücken, insbesondere Schraubenfedern, in der die Werkstücke elektromagnetisch erzeugten Kräften ausgesetzt werden, wobei zum Erzeugen der elektromagnetischen Kräfte Magnetsysteme vorgesehen sind, die durch Wechselstrom erregt werden.

Während bei der Bearbeitung von Werkstücken durch Entwicklung neuer Verfahren laufend Fortschritte erzielt wurden und werden, stellt das zur Bearbeitung oder in der Montage erforderliche Vereinzeln und Ordnen von sich verhakenden im Haufwerk vorliegenden metallischen Werkstücken einen zunehmenden Engpaß dar, der die Einführung neuer Arbeitsstrukturen erschwert und die Mechanisierung in Vorfertigung und Montage behindert.

Zur Lösung dieses Problems wurden neben den manuellen auch selbsttätig ablaufende Verfahren entwickelt, die die Schwerkraft und den mechanischen Stoß wie z. B. bei Vibrationsförderern oder Schüttelbrettern oder den Strömungsimpuls in Zuführgeräten mit Preßluft nutzen. Diese Geräte werden im Versuch optimiert und mit werkstückspezifischen Ordnungseinrichtungen empirisch angepaßt.

Durch die DE-B2-2 222 326 sind ein Verfahren und eine Anordnung zum Vereinzeln von aus magnetischem Material bestehenden Gegenständen unter Verwendung einer Führungsbahn sowie eines sich entlang dieser Führungsbahn erstreckenden, in Bewegungsrichtung der Gegenstände an Stärke zunehmenden Magnetfelds bekannt. Durch das bekannte Gerät sollen die Gegenstände bereits vereinzelt abgegeben werden. Zur Lösung dieser Aufgabe wird bei dem bekannten Verfahren das Magnetfeld als insgesamt pulsierendes Feld aufrechterhalten. Die Aufrechterhaltung eines pulsierenden Magnetfeldes führt dazu, daß doppelt oder mehrfach übereinanderliegende Gegenstände ihre relative Lage zueinander aufgeben müssen, weil zwischen den Gegenständen starke Abstoßkräfte wirken, so daß die Gegenstände mit Sicherheit vereinzelt und geordnet werden.

Der Erfindung liegt die Aufgabe zugrunde, eine verbesserte Vorrichtung der genannten Art vorzuschlagen, die die Vereinzelungs- und Ordnungseffekte in einem bisher nicht beobachteten Ausmaße hervorbringt.

Bei einer Vorrichtung gemäß der Erfindung ist als Magnetsystem ein von dreiphasigem Wechselstrom erregter und in einem magnetisch nichtleitenden Material vergossener Stator eines Linearmotors vorgesehen. Auf dem Stator ist eine nichtmetallische Ordnungseinrichtung mit den als Haufwerk vorliegenden Werkstücken angeordnet. Die Ordnungseinrichtung weist senkrecht zur Richtung des im Stator erzeugten Wanderfeldes den Werkstücken angepaßte Nuten auf. Der Raum um den Stator ist durch eine magnetisch nichtleitende Abdeckung begrenzt.

Bei einer anderen Ausführungsform der Vorrichtung gemäß der Erfindung ist als Magnetsystem ein von dreiphasigem Wechselstrom erregter Stator eines Drehstrommotors vorgesehen. Der Innenraum des Stators ist mit einer magnetisch nichtleitenden Abdeckung versehen, die aus einem der Statorbohrung angepaßten Zylinder und zwei Plexiglasscheiben besteht. Senkrecht zur Richtung des im Stator erzeugten Drehfeldes und parallel zur Statorachse ist durch eine der Plexiglasscheiben eine Austragsrinne geführt.

Im Elektromaschinenbau war es zwar bekannt, daß die Kräfte des elektromagnetischen Wanderfeldes auch zur Förderung von Flüssigkeiten, metallischen Bändern und geordnetem Stückgut genutzt werden können. Die beobachteten Ausmaße von Vereinzelungs- und Ordnungseffekten, die das Wanderfeld bzw. das Drehfeld in einem bisher bei keinem anderen Verfahren in dieser deutlichen Ausprägung beobachteten Ausmaße hervorbringt, war jedoch überraschend.

Die Erfindung wird anhand der Zeichnung und von Ausführungsbeispielen noch näher beschrieben. Es zeigt:

Figur 1 in perspektivischer Darstellung eine Vorrichtung gemäß der Erfindung mit Ausnutzung eines Wanderfeldes,

Figur 2 in perspektivischer Darstellung eine Vorrichtung gemäß der Erfindung mit Ausnutzung eines Drehfeldes.

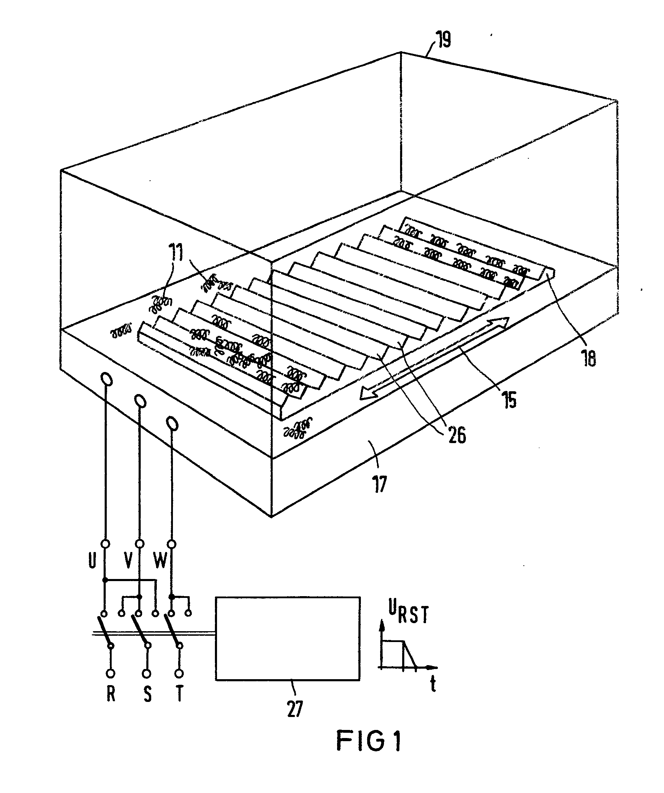

Fig. 1 zeigt den Aufbau einer Ausführungsform der Vorrichtung gemäß der Erfindung zum Durchführen des Verfahrens gemäß der Erfindung zum Vereinzeln und Ordnen zum Verhaken neigender Schraubenfedern. Auf einem zweckmäßigerweise in einem magnetisch nichtleitenden Material vergossenen Stator 17 eines Linearmotors wird eine nichtmetallische Ordnungseinrichtung 18 aufgelegt. Diese Ordnungseinrichtung 18 trägt den Schraubenfedern 11 angepaßte Nuten 26 senkrecht zur Wanderfeldrichtung 15. Der Raum um die Vorrichtung herum ist begrenzt durch eine Plexiglashaube 19. Ein Haufwerk von Schraubenfedern 11 wird auf die Vorrichtung gegeben. Wird das Drehstromwicklungssystem des Linearmotorstators 17 ans Netz $U_{RST}$ gelegt, so löst sich das Haufwerk 11 unter stochastischen Bewegungen der sich in Rotation versetzenden sich abstoßenden und senkrecht zur Wanderfeldrichtung 15, parallel zu den Nuten 26 ausrichtenden Federn 11 allmählich auf und wandert entgegen der Feldrichtung über die Ordnungseinrichtung 18. Dabei bleiben insbesondere die vereinzelten Federn in den Nuten 26 liegen. Durch Phasenumkehr kann die Wanderfeldrichtung 15 umgekehrt und so die Vorrichtung in mehreren Durchläufen gefüllt werden. Dieser Ablauf kann visuell gesteuert oder von einer Automatik 27, z. B. einem Taktgeber, übernommen werden. Beim Abschalten des Vorgangs kann die Spannung nicht schlagartig, sondern nach einer Funktion gegen Null zurückgenommen werden, so daß die Schraubenfedern entmagnetisiert in der Vorrichtung liegen. Vollständigkeitskontrolle, Entnahme der vereinzelten und geordneten Schraubenfedern oder deren Weiterverarbeitung im erzielten Muster können nach bereits bekannten Verfahren vorgenommen werden.

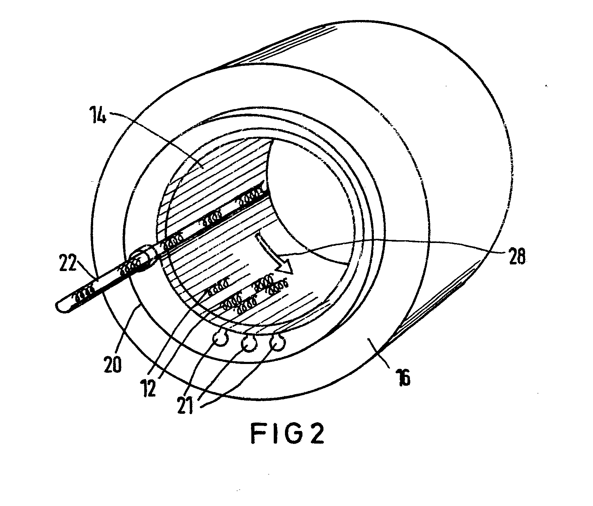

Fig. 2 zeigt eine weitere Ausführungsform der erfindungsgemäßen Vorrichtung, bei der das Vereinzeln und Ordnen stattfindet, wenn Schraubenfedern 12 als Haufwerk in das Drehfeld 14 eines Drehstrommotorstators 16 gegeben werden. Der Innenraum des Stators 16 ist von einem magnetisch nichtleitenden Zylinder 20 und zwei Deckeln aus Plexiglas abgedeckt. Aus dem in Innenraum unter stochastischen Bewegungen vereinzelter und noch verhakender Schraubenfedern kreisenden Haufwerk 12 können mit einer nur vereinzelte, zur Drehfeldrichtung senkrecht, zur Statorachse parallelliegende, Schraubenfedern aufnehmenden Austragungsrinne 22 auch Zuführaufgaben verwirklicht werden, bei denen die Schraubenfedern zur weiteren Verarbeitung einer einzigen Entnahmestelle zuzuführen sind. Der Pfeil 28 zeigt die Wanderrichtung der Schraubenfedern 12 an.

## Ansprüche

1. Vorrichtung zum Vereinzeln und Ordnen von sich verhakenden im Haufwerk vorliegenden metallischen Werkstücken (11), insbesondere Schraubenfedern, in der die Werkstücke elektromagnetisch erzeugten Kräften ausgesetzt werden, wobei zum Erzeugen der elektromagnetischen Kräfte Magnetsysteme vorgesehen sind, die durch Wechselstrom erregt werden, dadurch gekennzeichnet, daß als Magnetsystem ein von dreiphasigem Wechselstrom erregter und in einem magnetisch nichtleitenden Material vergossener Stator (17) eines Linearmotors vorgesehen ist, daß auf dem Stator (17) eine nichtmetallische Ordnungseinrichtung (18) mit den als Haufwerk vorliegenden Werkstücken (11) angeordnet ist, daß ferner die Ordnungseinrichtung (18) senkrecht zur Richtung des im Stator (17) erzeugten Wanderfeldes (18) den Werkstücken (11) angepaßte Nuten (26) aufweist und daß der Raum um den Stator (17) durch eine magnetisch nichtleitende Abdeckung (19) begrenzt ist.

2. Vorrichtung zum Vereinzeln und Ordnen von sich verhaken im Haufwerk vorliegenden metallischen Werkstücken, insbesondere Schraubenfedern, in der die Werkstücke elektromagnetisch erzeugten Kräften ausgesetzt werden, wobei zum Erzeugen der elektromagnetischen Kräfte Magnetsysteme vorgesehen sind, die durch Wechselstrom erregt werden, dadurch gekennzeichnet, daß als Magnetsystem ein von dreiphasigem Wechselstrom erregter Stator (16) eines Drehstrommotors vorgesehen ist, daß der Innenraum des Stators (16) mit einer magnetisch nichtleitenden Abdeckung (20) versehen ist, die aus einem der Statorbohrung angepaßten Zylinder und zwei Plexiglasscheiben besteht und daß senkrecht zur Richtung des im Stator (16) erzeugten Drehfeldes (28) und parallel zur Statorachse durch eine der Plexiglasscheiben eine Austragsrinne (22) geführt ist.

## Claims

1. A device for separating and orientating metallic workpieces (11), in particular spiral springs, stacked and hooked on each other, wherein the workpieces are exposed to electromagnetically produced forces, where in order to produce the electromagnetic forces, magnetic systems excited by alternating current are provided, characterised in that a stator (17) of a linear motor excited by a three-phase alternating current and cast in a non-magnetic material is provided as a magnetic system, that on the stator (17), there is arranged a non-metallic orientating device (18) with the stacked workpieces (11), that moreover the orientating device (18) has grooves (26) matched to the workpieces (11) and at right angles to the direction of the travelling wave (18) produced in the stator (17), and that the space around the stator (17) is delimited by a non-magnetic cover (19).

2. A device for separating and orientating metallic workpieces, in particular spiral springs, stacked and hooked one to another, wherein the workpieces are exposed to electromagnetically produced forces, where in order to produce the electromagnetic forces, magnetic systems excited by alternating current are provided, characterised in that a stator (16) of a three-phase commutator motor excited by a three-phase alternating current is provided, that the interior of the stator (16) is provided with a non-magnetic cover (20) consisting of a cylinder matched to the stator bore and of two plexi-glass panes, and that a discharge channel (22) is led through one of the plexi-glass panes at right angles to the direction of the rotary field (28) produced in the stator (16) and parallel to the stator axis.

## Revendications

1. Dispositif pour séparer et ranger des pièces métalliques (11) en vrac et s'accrochant mutuellement, en particulier des ressorts hélicoïdaux, du type dans lequel les pièces sont exposées à des forces produites par voie électromagnétique, des systèmes magnétiques, excités par un courant alternatif étant prévus pour produire les forces électromagnétiques, caractérisé par le fait que l'on prévoit, comme système magnétique un stator (17) d'un moteur linéaire, excité par un courant triphasé et moulé dans un matériau non magnétiquement conducteur, que sur le stator

(17) est monté un dispositif de rangement (18) avec les pièces (11) en vrac, qu'en outre le dispositif de rangement (18) comporte des gorges (26) perpendiculaires à la direction du champ d'ondes progressives (18) produit dans le stator (17) et adaptées aux pièces, et que l'espace autour du stator (17) est délimité par un couvercle (19) en un matériau non magnétiquement conducteur.

2. Dispositif pour séparer et ranger des pièces métalliques (11) en vrac et s'accrochant mutuellement, en particulier des ressorts hélicoïdaux, du type dans lequel les pièces sont exposées à des forces produites par voie électromagnétique, des systèmes magnétiques, excités par un courant alternatif étant prévus pour produire les forces électromagnétiques, caractérisé par le fait que l'on prévoit, comme système magnétique le stator (16) d'un moteur à courant alternatif alimenté par un courant triphasé, que l'espace extérieur du stator est pourvu d'un couvercle (20) en un matériau non magnétiquement conducteur et constitué par un cylindre adapté à l'alésage du stator et par des disques en plexiglass, et que perpendiculairement à la direction du champ tournant (26) produit dans le stator (16) et parallèlement à l'axe du stator, une goulotte d'évacuation (22) passe par les disques en plexiglass.

FIG 1

FIG 2